# EUROPEAN PATENT APPLICATION

(11) **EP 0 896 364 A1**
(43) Date of publication of application: **10.02.1999**
(21) Application number: 98305989.0
(22) Date of filing: 28.07.1998
(51) Int. Cl.: H01L 21/336, H01L 21/285, H01L 29/45, H01L 29/78

(54) **Method of making a field-effect transistor with self-aligned TiSi2/TiN source and drain contacts**

(30) Priority: 07.08.1997 US 907408
(71) Applicant: LUCENT TECHNOLOGIES INC., Murray Hill, New Jersey 07974-0636 (US)
(72) Inventor: Hillenius, Steven James, Summit, New Jersey 07901 (US); Pai, Chien-Shing, Bridgewater, New Jersey 08807 (US); Liu, Chun-Ting, Berkeley Heights, New Jersey 07922 (US)
(74) Representative: Johnston, Kenneth Graham

(57) **Abstract**

In accordance with the invention, a MOS field effect device is fabricated with TiSi₂ or other group VIII metal silicide contacts or landing pads using only one silicide anneal step. The process provides enhanced thickness control and interface quality.

## Description

### FIELD OF THE INVENTION

This invention relates to methods of making MOS field effect transistors (MOSFETs) and, in particular, to an improved method for making MOSFETS with self-aligned TiSi₂/TiN contacts and local interconnects.

### BACKGROUND OF THE INVENTION

Field effect devices, such as field effect transistors, are fundamental components in modern electronics. They are basic components in most digital and many analog circuits, including circuits for data processing and telecommunications. Indeed it has been surmised that field effect transistors are among the most numerous of human-made objects.

A typical MOS field effect transistor comprises a silicon surface including a controllable-conductivity path, called a channel, disposed between a source and a drain. A gate electrode (the "metal" of MOS) is formed on a thin film of dielectric (the "oxide" of MOS) overlying the channel (the "silicon"). For example, the source and the drain can be n-type regions of silicon and the channel can be a p-type region connecting them. The gate electrode can be a conductively-doped polysilicon layer formed on a thin layer of silicon oxide dielectric overlying the channel.

In a normally-off transistor, if no voltage is applied to the gate, current cannot flow from the source to the channel or from the channel to the drain. However if a sufficient positive voltage is applied to the gate, electrons are induced into the channel region, thereby creating a continuous n-type conductive path between the source and the drain. Alternatively the channel can be a n-type region between a p-type source and a p-type drain. A negative voltage at the gate will induce a continuous p-type path between the source and the drain.

Historically, the development of self-aligned processes for making field effect devices has contributed greatly to the miniaturization of integrated circuits. One major contributor to miniaturization was the development of the self-aligned silicon gate process wherein the polysilicon gate is used as a mask protecting the channel region when the source and drain regions are formed.

A more recent advance is the development of the self-aligned silicide contact process wherein metal silicides forming selectively on exposed regions of silicon are used to enhance conductivity and reduce the source/drain junction areas. This reduces junction capacitance and improves circuit performance.

TiSi₂ and other group VIII metal silicides are especially attractive for self-aligned contact landing pads and local interconnects to silicon. Among their advantages are lower resistivity as compared with refractory metal silicides, low reaction temperature with silicon (< 650° C), maintenance of a high doping concentration at the silicide-silicon interface, and the availability of chemical etchants to selectively remove unreacted metal.

A disadvantage of conventional methods for making contacts and landing pads of such silicides is that they typically involve at least two separate heating steps. The conventional process, starting after the source/drain anneal involves the following steps: 1) deposition of a layer Ti, 2) implanting Si to amorphise the Si surface, 3) a first rapid thermal annealing at 640° C for about 30 s to form TiSi₂ of phase C₄₉ 4) wet etching to remove unreacted Ti and to separate the source, gate and drain, and 5) a second rapid thermal anneal at about 840° C for 10 s. to form stabilized TiSi₂ of phase C₅₄.

This process presents a number of disadvantages. First, during the initial annealing, the Ti is not fully reacted. Consequently the final thickness of TiSi₂ is uncertain. Second, the annealing steps are normally in an N₂ ambient. Since N₂ reacts with Ti at the top surface to form TiN, there is a loss of Ti contributing to the uncertainty of the TiSi₂ thickness. Third, impurities diffuse through the TiSi₂ during the second annealing step, adversely affecting TiSi₂ uniformity and the quality of the Si/TiSi₂ interface. These disadvantages become increasingly significant as device dimensions and the TiSi₂ thickness scale down. Accordingly there is a need for a new process to provide enhanced control of thickness and interface quality.

### SUMMARY OF THE INVENTION

In accordance with the invention, a MOS field effect device is fabricated with TiSi2 or other group VIII metal silicide contacts or landing pads using only one silicide anneal step. The process provides enhanced thickness control and interface quality.

### BRIEF DESCRIPTION OF THE DRAWINGS

The advantages, nature and various additional features of the invention will appear more fully upon consideration of the illustrative embodiments now to be described in detail in connection with the accompanying drawings:
Fig. 1 is a flow diagram illustrating the steps in fabricating a MOS field effect device having silicide contacts or landing pads; and
Figs. 2A-2C are schematic cross sections of the device at various stages of the process of Fig. 1.

It is to be understood that these drawings are for purposes of illustrating the concepts of the invention and are not to scale.

### DETAILED DESCRIPTION

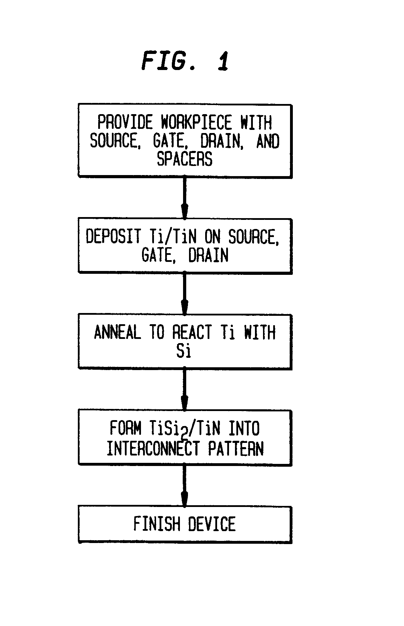

Referring to the drawings, Fig. 1 is a schematic flow diagram of the steps in an improved self-aligned silicide contact process. The initial step, shown in block A, is to provide a workpiece having a source, gate and drain for a silicon-gate MOS field effect device, including a pair of side wall spacers on either side of the silicon gate. Such a workpiece is conveniently and conventionally provided by applying the well-known self-aligned silicon gate process to a monocrystalline silicon substrate. The sidewall spacers are formed by depositing a dielectric layer over the gate, source and drain and etching back to define the spacers. Further details are set forth in *C. Y. Chang and S.M. Sze, ULSI Technology, Ch.9 (McGraw-Hill, 1996),* which is incorporated herein by reference.

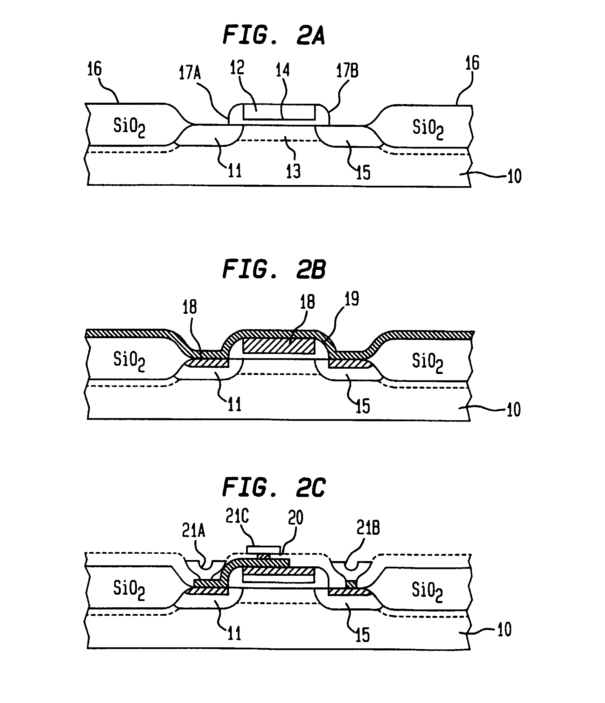

Fig. 2A illustrates the workpiece, comprising a monocrystalline silicon substrate 10, a source 11, a polysilicon gate 12 separated from a channel region 13 by a thin gate dielectric 14, such as silicon oxide, and a drain 15. A relatively thick field oxide 16 substantially surrounds the device on the surface of the substrate 10, and a pair of sidewall spacers 17A and 17B, formed by deposition and etch-back of a thick oxide layer, separate the gate from the surfaces of the source and drain regions.

The next step, shown in block B is to deposit a composite layer of Ti/TiN covering exposed silicon surfaces of the source, gate and drain. Preferred thicknesses are Ti in the range 10nm to 50nm and TiN in the range 10nm to 50nm. The layers can be conveniently deposited by sputtering.

The third step (block C) is a rapid thermal anneal at sufficient time and temperature to obtain reaction of the Ti with silicon. Preferably the anneal is at a temperature in the range 700° C - 850° C and preferably 800° C for a period of 30s - 60s. The TiN cap layer prevents impurity penetration and assists in obtaining a controlled, full reaction of the underlying Ti with Si. The higher temperature, as compared with the conventional 650° C, in addition to ensuring full reaction, provides uniform, high quality TiSi₂.

Fig. 2B shows the workpiece after this step with TiSi₂ layer 18 and TiN layer 19 on the exposed silicon of the source, gate and drain.

The next step shown in block D is to lithographically pattern the TiN layer into the desired pattern of contacts and local interconnects. The TiN layer can be etched as by dry reactive ion etching (RIE) or wet chemical etching.

The final step (Block E) is to finish the MOS field effect device in the conventional fashion, as by depositing a dielectric layer 20 over the silicided source, gate and drain in Fig. 2C. Aluminum contacts 21A, 21B and 21C can extend through the dielectric to make ohmic contact with the source and drain.

The invention will be more clearly understood upon consideration of the following specific example.

### Example

The method of Fig. 1 has been applied to the fabrication of 0.25µm CMOS circuits with the following process conditions. The physical length of the gate runners is 0.24µm, and the oxide spacers surrounding the gate runners are 80nm at the foot of the gate runners. Source, drain, and gate electrodes are implanted with 5X10¹⁵/cm² implant dose of arsenic and boron for the n-channel and p-channel devices, respectively. A thermal cycle of 1050°C for 10 seconds forms the desired doping profiles in those electrodes. A Ti layer of 15nm is sputtered on the wafers, covered by TiN layer of 25nm also deposited with sputtering. A rapid thermal anneal step of 800°C for 30 seconds is used for the reaction of the Ti layer with the exposed Si surfaces. Photo resist is then used to define the final patterns of the TiN layer which is either dry etched or wet etched on the areas not covered by the photo resist. The etch step has a selectivity of more than 20:1 between TiN and TiS₂. The unreacted Ti on areas originally covered by oxide, e.g., on the isolation areas, is also etched away during this etch step with the same etch rate as the TiN layer.

It is to be understood that the above-described embodiments are illustrative of only a few of the many possible specified embodiments which can represent applications of the principles of the invention. Numerous and varied other methods can be readily devised by those skilled in the art without departing from the spirit and scope of the invention.

## Claims

1. The method of making a field effect transistor comprising the steps of:
forming on a surface of a monocrystalline silicon substrate, a source and drain separated by a channel and a polycrystalline silicon gate having sidewalls, said gate overlying said channel and separated from said channel by an insulating layer; said source, drain and gate having exposed silicon surfaces;
forming dielectric sidewalls adjacent said gate sidewalls for separating said gate from said source and drain;
depositing a composite layer of titanium and titanium nitride overlying exposed silicon surfaces of said source, drain and gate, said titanium in contact with said silicon surfaces;
thermally annealing the resulting workpiece to obtain reaction of the titanium with the silicon;
patterning the composite layer into contacts and interconnects; and
finishing the field effect device

2. The method of claim 1 wherein said titanium is deposited to a thickness in the range 10nm to 50nm.

3. The method of claim 1 wherein said titanium nitride is deposited to a thickness in the range of 10nm to 50nm.

4. The method of claim 1 wherein said thermal annealing is at a temperature in the range 700° - 850°C.

5. The method of claim 4 wherein said thermal annealing is for a time in the range 30-60s.

6. the method of claim 1 wherein said patterning of titanium nitride comprises dry reactive ion etching or wet chemical etching.

7. A field effect transistor made by the process of claim 1.
